# EUROPEAN PATENT APPLICATION

(11) **EP 4 050 675 A1**
(43) Date of publication of application: **31.08.2022**
(21) Application number: 21193461.7
(22) Date of filing: 27.08.2021
(51) Int. Cl.: H01L 51/52, H01L 27/32

(54) **LIGHT-EMITTING DEVICE AND DISPLAY APPARATUS INCLUDING THE SAME**

(30) Priority: 25.02.2021 KR 20210025958
(71) Applicant: Samsung Electronics Co., Ltd., Suwon-si, Gyeonggi-do 16677 (KR)
(72) Inventor: SONG, Sunjin, 16678 Suwon-si (KR); KWON, Myongjong, 16678 Suwon-si (KR); JOO, Wonjae, 16678 Suwon-si (KR)
(74) Representative: Elkington and Fife LLP

(57) **Abstract**

Provided are a light-emitting device and a display apparatus. The light-emitting device includes: a reflective layer including a plurality of nano-structures that are two-dimensionally arranged in a regular periodic structure; a first electrode disposed on the plurality of nano-structures of the reflective layer; an organic emission layer disposed on the first electrode; and a second electrode disposed on the organic emission layer. An interval between adjacent nano-structures in a central portion of the reflective layer or an interval between adjacent nano-structures in a peripheral portion surrounding the central portion of the reflective layer is equal to or less than 70 nm.

## Description

### FIELD OF THE INVENTION

The disclosure relates to a light-emitting device and a display apparatus including the same, and more particularly to, an organic light-emitting device and an organic light-emitting display apparatus having high color purity even without using a color filter.

### BACKGROUND OF THE INVENTION

An organic light-emitting device (OLED) is a display device that forms an image when holes injected from an anode and electrons injected from a cathode combine with each other in an organic emission layer to emit light. The OLED has excellent display characteristics such as a wide viewing angle, a fast response time, a low thickness, a low manufacturing cost, and a high contrast.

Also, the OLED may emit light of a desired color by selecting an appropriate material as a material of the organic emission layer. According to this principle, a color display apparatus may be implemented by using the OLED. For example, an organic emission layer of a blue pixel may be formed of an organic material that generates blue light, an organic emission layer of a green pixel may be formed of an organic material that generates green light, and an organic emission layer of a red pixel may be formed of an organic material that generates red light. Also, a white OLED may be implemented by arranging in one organic emission layer a plurality of organic materials that respectively generate blue light, green light, and red light or by arranging pairs of two or more types of organic materials that are complementary to each other.

### SUMMARY OF THE INVENTION

Provided are an organic light-emitting device and an organic light-emitting display apparatus having high color purity even without using a color filter.

Provided is sub-micron sized organic light-emitting device.

Provided is an ultra-high resolution organic light-emitting display apparatus with sub-micron pixels.

Additional aspects will be set forth in part in the description which follows and, in part, will be apparent from the description, or may be learned by practice of the presented embodiments.

According to an aspect of the disclosure, there is provided a light-emitting device including a reflective layer including a plurality of nano-structures that are two-dimensionally arranged in a regular periodic structure; a first electrode provided on the plurality of nano-structures of the reflective layer; an organic emission layer provided on the first electrode; and a second electrode provided on the organic emission layer, wherein the reflective layer and the second electrode form a micro-cavity having a resonance wavelength, and the resonance wavelength of the micro-cavity is based on a width of each of the plurality of nano-structures, a height of each of the plurality of nano-structures, an interval between adjacent nano-structures, among the plurality of nano-structures, and a periodicity of the plurality of nano-structures, and wherein an interval between adjacent nano-structures in a central portion of the reflective layer or an interval between adjacent nano-structures in a peripheral portion surrounding the central portion of the reflective layer is equal to or less than 70 nm.

Embodiments of the invention may be applicable augmented reality, virtual reality (e.g. micro-sized), and vehicle displays (e.g. flexible), each using a highly integrated OLED display.

According to proposed embodiments, a meta-array which has a narrower spacing than the edge in a small pixel of a sub-micron size is arranged. A subpixel may have a size that is smaller than or equal to a sub-micron to implement an ultra-high resolution display. For example, a subpixel of a size about 1.2 µm in an RGBG pixel, which has four subpixels in one pixel, is a high-quality resolution display corresponding to 10,000 PPI. In this case, as a resonance mainly occurs in the meta-structure, as the pixel size decreases, the edge proportion of the pixel relatively increases so that the resonance area of the target wavelength is reduced, and thus, the efficiency is reduced.

According to an embodiment, there may be provided a light-emitting device including a pixel that comprises a meta reflective layer with two or more different regular periodic structures. The meta reflective layer may have a nanostructure of which periodicity is less than a wavelength of emission light. The meta reflective layer may have silver (Ag), aluminum (Al), etc. The height of the nanostructure of the meta reflective layer may be the same. The height of the nanostructure of the meta reflective layer may be 200 nm or less. The spacing of the nanostructure of the meta reflective layer may be 70 nm or less. The nanostructure of the reflective layer may have a 2-fold symmetry in plane of, for example, a cylindrical shape, a hexahedral or an inclined cylinder shape, and an inclined hexahedral shape. The light-emitting device may include pixels emitting blue or green or red light. The pixel may have the resolution of 8000 ppi.

According to another embodiment, there may be provided a light-emitting device including a pixel having a meta-reflective layer in which a spacing between periodic nanostructures is less than or equal to 70 nm.

According to yet another embodiment, there may be provided a light-emitting device including a meta reflective layer that comprises a plurality of subpixels with different emission lights, wherein at least one of the subpixels has more than two different regular periodic structures.

According to yet another embodiment, there may be provided a light-emitting device including a metal reflective layer having a metal reflective layer, wherein the plurality subpixels with different emission lights are formed and at least one of the subpixels has the periodic nanostructure spacing of 70 nm or less.

The width of each of the plurality of nano-structures of the reflective layer, the height of each of the plurality of nano-structures, the interval between the adjacent nano-structures, and the periodicity of the plurality of nano-structures are configured so that the resonance wavelength of the micro-cavity is matched to an emission wavelength of the light-emitting device.

The periodicity of the plurality of nano-structures is less than an emission wavelength band of the light-emitting device.

The periodicity of the plurality of nano-structures ranges from about 70 nm to about 300 nm.

The height of each of the plurality of nano-structures is equal to or less than 200 nm, and wherein each of the plurality of nano-structures of the reflective layer has a same height.

The width of each of the plurality of nano-structures of the reflective layer ranges from about 50 nm to about 200 nm.

The interval between the adjacent nano-structures in the central portion of the reflective layer or the interval between the adjacent nano-structures in the peripheral portion of the reflective layer ranges from about 10 nm to about 70 nm.

A width of the light-emitting device is equal to or less than 2 µm.

The reflective layer includes a plurality of first nano-structures arranged in the central portion of the reflective layer and a plurality of second nano-structures arranged in the peripheral portion of the reflective layer, wherein a first interval between two adjacent nano-structures from among the plurality of first nano-structures is less than a second interval between two adjacent nano-structures from among the plurality of second nano-structures.

A first width of each of the plurality of first nano-structures is same as a second width of each of the plurality of second nano-structures.

The reflective layer includes a plurality of first nano-structures arranged in the central portion of the reflective layer and a plurality of second nano-structures arranged in the peripheral portion of the reflective layer, wherein a first interval between two adjacent nano-structures from among the plurality of second nano-structures is less than a second interval between two adjacent nano-structures from among the plurality of first nano-structures.

The reflective layer includes a plurality of first nano-structures and a plurality of second nano-structures arranged in the central portion of the reflective layer, and a plurality of third nano-structures arranged in the peripheral portion of the reflective layer, wherein a first interval between two adjacent nano-structures from among the plurality of first nano-structures is different from a second interval between two adjacent nano-structures from among the plurality of second nano-structures, and the second interval between two adjacent nano-structures from among the plurality of second nano-structures is different from a third interval between two adjacent nano-structures from among the plurality of third nano-structures.

A first periodicity of the plurality of first nano-structures is same as a second periodicity of the plurality of second nano-structures.

A first width of each of the plurality of first nano-structures is different from a second width of each of the plurality of second nano-structures, and the second width of each of the plurality of second nano-structures is same as a third width of each of the plurality of third nano-structures.

The plurality of first nano-structures and the plurality of second nano-structures are arranged together in the central portion of the reflective layer.

The plurality of second nano-structures are arranged in a portion surrounding the plurality of first nano-structures, and the plurality of third nano-structures are arranged in a portion surrounding the plurality of second nano-structures.

The second interval between two adjacent nano-structures from among the plurality of second nano-structures is less than the third interval between two adjacent nano-structures from among the plurality of third nano-structures, and a first periodicity of the plurality of first nano-structures is less than a third periodicity of the plurality of third nano-structures, and a second periodicity period of the plurality of second nano-structures is less than a third periodicity of the plurality of third nano-structures.

The first interval between two adjacent nano-structures from among the plurality of first nano-structures is less than the second interval between two adjacent nano-structures from among the plurality of second nano-structures, and the second interval between two adjacent nano-structures from among the plurality of second nano-structures is less than the third interval between two adjacent nano-structures from among the plurality of third nano-structures.

The interval between adjacent nano-structures in an entire portion of the reflective layer is same.

According to another aspect of the disclosure, there is provided a display apparatus including a first pixel configured to emit light of a first wavelength band; and a second pixel configured to emit light of a second wavelength band different from the first wavelength band, wherein the first pixel includes: a reflective layer including a plurality of nano-structures that are two-dimensionally arranged in a regular periodic structure; a first electrode provided on the plurality of nano-structures of the reflective layer; an organic emission layer provided on the first electrode; and a second electrode provided on the organic emission layer, wherein the reflective layer and the second electrode form a micro-cavity having a resonance wavelength, and the resonance wavelength of the micro-cavity is based on a width of each of the plurality of nano-structures, a height of each of the plurality of nano-structures, an interval between adjacent nano-structures, among the plurality of nano-structures, and a periodicity of the plurality of nano-structures, and wherein an interval between adjacent nano-structures in a central portion of the reflective layer or an interval between adjacent nano-structures in a peripheral portion surrounding the central portion of the reflective layer is equal to or less than 70 nm.

The reflective layer includes a plurality of first nano-structures arranged in the central portion of the reflective layer and a plurality of second nano-structures arranged in the peripheral portion of the reflective layer, wherein a first interval between two adjacent nano-structures from among the plurality of first nano-structures is less than as second interval between two adjacent nano-structures from among the plurality of second nano-structures.

The reflective layer includes a plurality of first nano-structures arranged in the central portion of the reflective layer and a plurality of second nano-structures arranged in the peripheral portion of the reflective layer, wherein a first interval between two adjacent nano-structures from among the plurality of second nano-structures is less than a second interval between two adjacent nano-structures from among the plurality of first nano-structures.

The reflective layer includes a plurality of first nano-structures and a plurality of second nano-structures arranged in the central portion of the reflective layer and a plurality of third nano-structures arranged in the peripheral portion of the reflective layer, wherein a first interval between two adjacent nano-structures from among the plurality of first nano-structures is different from a second interval between two adjacent nano-structures from among the plurality of second nano-structures, and the second interval between two adjacent nano-structures from among the plurality of second nano-structures is different from a third interval between two adjacent nano-structures from among the plurality of third nano-structures.

The interval between adjacent nano-structures in an entire portion of the reflective layer is same.

A width of each of the first pixel and the second pixel is equal to or less than 2 µm.

The width of the each nano-structure is a diameter of the each nano-structure.

According to another aspect of the disclosure, there is provided a light-emitting device including a reflective layer including a plurality of nano-structures that are two-dimensionally arranged; a first electrode provided on the plurality of nano-structures of the reflective layer; an organic emission layer provided on the first electrode; and a second electrode provided on the organic emission layer, wherein the reflective layer and the second electrode form a micro-cavity having a resonance wavelength, and wherein a first interval between adjacent nano-structures in a central portion of the reflective layer or a second interval between adjacent nano-structures in a peripheral portion surrounding the central portion of the reflective layer is equal to or less than 70 nm.

According to another aspect of the disclosure, there is provided a light-emitting device including a reflective layer including a plurality of nano-structures that are two-dimensionally arranged; a first electrode provided on the plurality of nano-structures of the reflective layer; an organic emission layer provided on the first electrode; and a second electrode provided on the organic emission layer, wherein the reflective layer and the second electrode form a micro-cavity having a resonance wavelength, and wherein a first interval between a plurality of adjacent nano-structures in a central portion of the reflective layer is different from a second interval between a plurality of adjacent nano-structures in a peripheral portion surrounding the central portion of the reflective layer.

### BRIEF DESCRIPTION OF THE DRAWINGS

The above and other aspects, features, and advantages of certain embodiments will be more apparent from the following description taken in conjunction with the accompanying drawings, in which:
FIG. 1 is a cross-sectional view illustrating a structure of a light-emitting device according to an example embodiment.
FIG. 2 is a detailed cross-sectional view illustrating a structure of an organic emission layer of FIG. 1, according to an example embodiment;
FIG. 3 is a detailed cross-sectional view illustrating a structure of the organic emission layer of FIG. 1, according to another example embodiment;
FIG. 4A is a plan view illustrating an arrangement of a plurality of nano-structures of a reflective layer of FIG. 1;
FIG. 4B is a perspective view illustrating an arrangement of a plurality of nano-structures of the reflective layer of FIG. 1;
FIG. 5 is a graph illustrating emission characteristics of a light-emitting device according to a size of the light-emitting device and an interval between two adjacent nano-structures;
FIG. 6 is a plan view illustrating an arrangement of a plurality of nano-structures in a reflective layer, according to an example embodiment;
FIG. 7 is a plan view illustrating an arrangement of a plurality of nano-structures in a reflective layer, according to another example embodiment;
FIG. 8 is a graph illustrating emission characteristics of a light-emitting device including reflective layers of FIGS. 6 and 7;
FIG. 9A is a view illustrating an emission area and an emission intensity inside an organic emission layer of a light-emitting device including a reflective layer of FIG. 6; FIGS. 9B and 9C are views each illustrating an emission area and an emission intensity inside an organic emission layer of a light-emitting device according to comparative examples;
FIG. 10 is a plan view illustrating an arrangement of a plurality of nano-structures in a reflective layer, according to another example embodiment;
FIG. 11 is a graph illustrating emission characteristics of a light-emitting device including a reflective layer of FIG. 10;
FIG. 12A is a view illustrating an emission area and an emission intensity inside an organic emission layer of a light-emitting device including a reflective layer of FIG. 10; FIG. 12B is a view illustrating an emission area and an emission intensity inside an organic emission layer of a light-emitting device according to a comparative example;
FIG. 13 is a plan view illustrating an arrangement of a plurality of nano-structures in a reflective layer, according to another example embodiment;
FIG. 14 is a plan view illustrating an arrangement of a plurality of nano-structures in a reflective layer, according to another example embodiment;
FIG. 15 is a graph illustrating emission characteristics of a light-emitting device including reflective layers of FIGS. 13 and 14;
FIG. 16 is a cross-sectional view illustrating a structure of a light-emitting device, according to another example embodiment;
FIG. 17 is a cross-sectional view illustrating a structure of a display apparatus, according to an example embodiment; and
FIG. 18 is a cross-sectional view illustrating a structure of a display apparatus, according to another example embodiment.

### DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a light-emitting device and a display apparatus including the same will be described in detail with reference to the accompanying drawings. Like reference numerals denote like elements throughout, and in the drawings, sizes of elements may be exaggerated for clarity and convenience of explanation. Also, the example embodiments described below are merely examples, and various modifications may be made from the example embodiments.

When an element is referred to as being "on" another element, it may be directly on the other element, or intervening elements may be present therebetween. The singular forms "a," "an," and "the" are intended to include the plural forms as well, unless the context clearly indicates otherwise. When a portion "includes" an element, another element may be further included, rather than excluding the existence of the other element, unless otherwise described.

The use of the terms "a" and "an," and "the" and similar referents in the context of describing the present disclosure is to be construed to cover both the singular and the plural. The steps of all methods described herein may be performed in any suitable order unless otherwise indicated herein or otherwise clearly contradicted by context, and are not limited to the described order.

The terms such as "unit" or "module" refer to units that perform at least one function or operation, and the units may be implemented as hardware or software or as a combination of hardware and software.

Also, lines or members connecting elements illustrated in the drawings are merely illustrative of functional connections and/or physical or circuit connections. In an actual device, the connections between components may be represented by various functional connections, physical connections, or circuit connections that are replaceable or added.

The use of any and all examples, or language provided herein, is intended merely to better describe the disclosure and does not pose a limitation on the scope of the disclosure unless otherwise claimed.

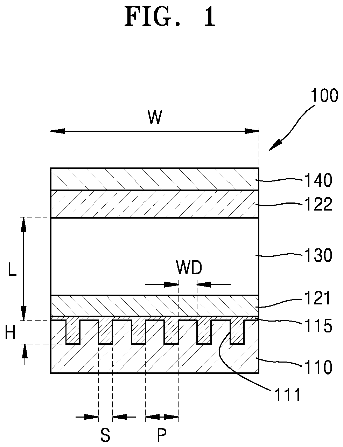

FIG. 1 is a cross-sectional view illustrating a structure of a light-emitting device according to an example embodiment. Referring to FIG. 1, a light-emitting device 100 may include a reflective layer 110 including a plurality of nano-structures 111 that are two-dimensionally arranged in a regular periodic structure, a first electrode 121 disposed on the reflective layer 110, an organic emission layer 130 disposed on the first electrode 121, and a second electrode 122 disposed on the organic emission layer 130.

The light-emitting device 100 may further include a passivation layer 140 that is transparent and is disposed on the second electrode 122. According to an example embodiment, the passivation layer 140 may protect the second electrode 122. Also, the light-emitting device 100 may further include a planarization layer 115 disposed between the reflective layer 110 and the first electrode 121 to planarize a bottom surface of the first electrode 121. Each of the planarization layer 115 and the passivation layer 140 may be formed of a material through which light generated by the organic emission layer 130 is transmitted. The planarization layer 115 may be disposed on the reflective layer 110 to contact all of the nano-structures 111 of the reflective layer 110. To this end, a bottom surface of the planarization layer 115 may be filled between the nano-structures 111, and may have a shape complementary to a shape of the nano-structures 111 formed on a top surface of the reflective layer 110. A top surface of the planarization layer 115 is flat, and the first electrode 121 is disposed on the top surface of the planarization layer 115.

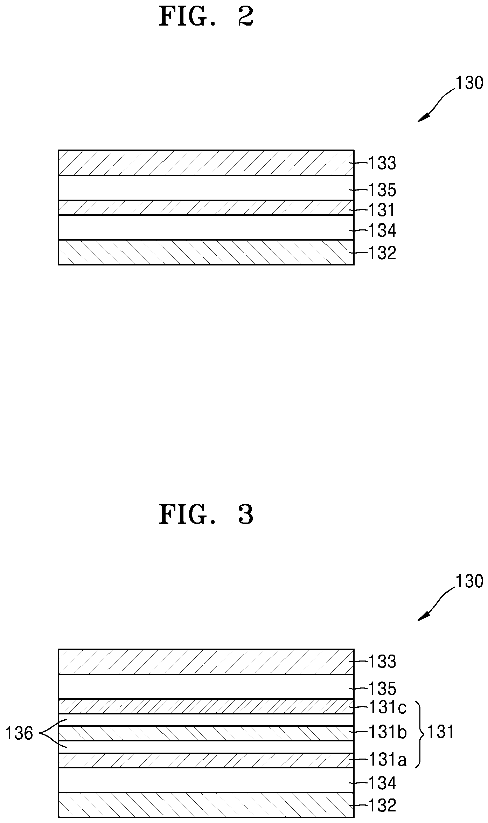

The light-emitting device 100 may be an organic light-emitting diode (OLED). For example, FIG. 2 is a detailed cross-sectional view illustrating a structure of the organic emission layer 130 of FIG. 1, according to an example embodiment. Referring to FIG. 2, the organic emission layer 130 may include a hole injection layer 132 disposed on a top surface of the first electrode 121, an organic emission material layer 131 disposed on the hole injection layer 132, and an electron injection layer 133 disposed on the organic emission material layer 131. In this structure, light is generated by recombination of holes injected by the hole injection layer 132 and electrons injected by the electron injection layer 133 in the organic emission material layer 131. A wavelength of the generated light may be determined by an energy band gap of a light-emitting material of the organic emission material layer 131.

Also, the organic emission layer 130 may further include a hole transfer layer 134 disposed between the hole injection layer 132 and the organic emission material layer 131 to facilitate hole transfer. Also, the organic emission layer 130 may further include an electron transfer layer 135 disposed between the electron injection layer 133 and the organic emission material layer 131 to facilitate electron transfer. Also, according to another example embodiment, the organic emission layer 130 may include various additional layers when necessary. For example, the organic emission layer 130 may further include an electron block layer between the hole transfer layer 134 and the organic emission material layer 131, and may further include a hole block layer between the organic emission material layer 131 and the electron transfer layer 135.

The organic emission material layer 131 may be configured to emit visible light. For example, the organic emission material layer 131 may be configured to emit light in any one of a wavelength band corresponding to red light, a wavelength band corresponding to green light, and a wavelength band corresponding to blue light. Or, the organic emission material layer 131 may be configured to emit white visible light including all of red light, green light, and blue light.

For example, FIG. 3 is a detailed cross-sectional view illustrating a structure of the organic emission layer 130 of FIG. 1, according to another example embodiment. Referring to FIG. 3, the organic emission material layer 131 may include a first organic emission material layer 131a emitting red light, a second organic emission material layer 131b emitting green light, and a third organic emission material layer 131c emitting blue light. Also, according to an example embodiment, one or more exciton blocking layers 136 may be provided in the organic emission layer 130. For instance, an exciton blocking layer 136 may be disposed between the first organic emission material layer 131a and the second organic emission material layer 131b and an exciton blocking layers 136 may be disposed between the second organic emission material layer 131b and the third organic emission material layer 131c. In this case, the organic emission layer 130 may emit white light. However, a structure of the organic emission layer 130 that emits white light is not limited thereto. Instead of including three organic emission material layers, that is, the first through third organic emission material layers 131a, 131b, and 131c, the organic emission layer 130 may include two organic emission material layers that are complementary colors to each other.

According to an example embodiment, the first electrode 121 disposed on a bottom surface of the organic emission layer 130 may function as an anode that provides holes. According to an example embodiment, the second electrode 122 disposed on a top surface of the organic emission layer 130 may function as a cathode that provides electrons. According to an example embodiment, the first electrode 121 may be formed of a material having a relatively high work function, and the second electrode 122 may be formed of a material having a relatively low work function.

Also, the first electrode 121 may be a transparent electrode through which light (e.g., visible light) is transmitted. For example, the first electrode 121 may include a transparent conductive oxide such as indium tin oxide (ITO), indium zinc oxide (IZO), or aluminum zinc oxide (AZO).

The second electrode 122 may be a semi-transmissive electrode that reflects part of light and transmits another part of the light. To this end, the second electrode 122 may include a very thin reflective metal. For example, the second electrode 122 may be formed of silver (Ag), aluminum (Al), gold (Au), nickel (Ni), or an alloy thereof, or may have a two-layer structure including silver (Ag) and magnesium (Mg) or a two-layer structure including aluminum (Al) and lithium (Li). A total thickness of the second electrode 122 may range from about 10 nm to about 50 nm. Because the second electrode 122 is very thin, part of light may pass through the reflective metal.

The reflective layer 110 may be configured to reflect light generated by the organic emission layer 130 and transmitted through the first electrode 121. Also, the reflective layer 110 may be formed of a conductive material. To this end, the reflective layer 110 may be formed of silver (Ag), gold (Au), aluminum (Al), nickel (Ni), or an alloy thereof. However, the present disclosure is not limited thereto, and the reflective layer 110 may include another reflective material as long as the reflective layer 110 has a high reflectance and high conductivity.

The reflective layer 110 and the second electrode 122 may constitute a micro-cavity. In other words, the micro-cavity may be formed between the reflective layer 110 and the second electrode 122 of the light-emitting device 100. For example, light generated by the organic emission layer 130 may reciprocate and resonate between the reflective layer 110 and the second electrode 122, and then light corresponding to a resonance wavelength of the micro-cavity may be emitted to the outside through the second electrode 122.

The resonance wavelength of the micro-cavity formed between the reflective layer 110 and the second electrode 122 may be determined by an optical length L of the micro-cavity. For example, when the resonance wavelength of the micro-cavity is λ, the optical length L of the micro-cavity may be nλ/2 (n is a natural number). The optical length L of the micro-cavity may be determined by a sum of an optical thickness of layers constituting the micro-cavity between the reflective layer 110 and the second electrode 122, a phase delay by the second electrode 122, and a phase shift (e.g., a phase delay ) by the reflective layer 110. Here, the optical thickness of the layers constituting the micro-cavity between the reflective layer 110 and the second electrode 122 is not a simple physical thickness, but is a thickness considering refractive indexes of materials of the layers constituting the micro-cavity. For example, the optical thickness of the layers constituting the micro-cavity may be a sum of an optical thickness of the planarization layer 115, an optical thickness of the first electrode 121, and an optical thickness of the organic emission layer 130.

According to the example embodiment, the optical length L or the resonance wavelength of the micro-cavity may be adjusted by adjusting only the phase shift by the reflective layer 110 while fixing the optical thickness of the layers constituting the micro-cavity and the phase delay by the second electrode 122. In order to adjust the phase shift by the reflective layer 110, a phase modulation surface is formed on a reflective surface of the reflective layer 110 facing the first electrode 121. The phase modulation surface may include very small nano-structures. For example, the phase modulation surface of the reflective layer 110 may have a meta-structure in which nano-structures having a size smaller than a wavelength of visible light are periodically arranged.

Referring back to FIG. 1, the reflective layer 110 may include the phase modulation surface having the meta-structure formed on the top surface facing the first electrode 121. The phase modulation surface of the reflective layer 110 may include a plurality of nano-structures 111 regularly and periodically arranged on the top surface of the reflective layer 110. The plurality of nano-structures 111 may have post shapes protruding from the top surface toward the first electrode 121. For example, each of the plurality of nano-structures 111 may have a cylindrical shape or a polygonal column shape. The plurality of nano-structures 111 may be integrally formed with the reflective layer 110 on the top surface of the reflective layer 110.

For example, when each nano-structure 111 has a cylindrical shape, optical characteristics (e.g., the phase delay of reflected light) of the phase modulation surface may be determined by a diameter of each nano-structure 111, a height H of each nano-structure 111, an interval S between two adjacent nano-structures 111, and a pitch or period P of the plurality of nano-structures 111. When each nano-structure 111 has a polygonal column shape, optical characteristics of the phase modulation surface may be determined by a maximum width of each nano-structure 111, the height H of each nano-structure 111, the interval S between two adjacent nano-structures 111, and the pitch or period P of the plurality of nano-structures 111. Hereinafter, a diameter or a maximum width of each nano-structure 111 is referred to as a width dimension WD of the nano-structure 111.

When a size of each nano-structure 111 of the phase modulation surface is less than a resonance wavelength, incident light resonates in a peripheral portion of the nano-structures 111 to form a plurality of nano-optical resonance structures. In particular, an electric field component of the incident light does not penetrate into a space between the nano-structures 111 and only a magnetic field component resonates in the peripheral portion of the nano-structures 111. Accordingly, the plurality of nano-optical resonance structures formed in the space between the nano-structures 111 are cylinder-type magnetic resonators in which the magnetic field component of the incident light resonates in the peripheral portion of the nano-structures 111. Also, phase modulation occurs due to a combination of nano-optical resonance by the individual nano-structures 111 and collective plasmon resonance by the plurality of nano-structures 111. As a result, a phase shift greater than a simple phase shift due to an effective optical distance (H × n) that is determined to be the product of the height H of the nano-structures 111 and a refractive index n of the nano-structures 111 may occur on the phase modulation surface of the reflective layer 110.

Accordingly, the resonance wavelength of the micro-cavity may be determined by the width dimension WD of each nano-structure 111 of the phase modulation surface, the height H of each nano-structure 111, the interval S between two adjacent nano-structures 111, and the period P of the plurality of nano-structures 111. In other words, the width dimension WD of each nano-structure 111 of the phase modulation surface, the height H of each nano-structure 111, the interval S between two adjacent nano-structures 111, and the period P of the plurality of nano-structures 111 may be selected so that when the resonance wavelength of the micro-cavity is λ, the optical length L of the micro-cavity satisfies nλ/2 (n is a natural number).

Accordingly, the resonance wavelength of the micro-cavity may be easily matched to an emission wavelength or an emission color of the light-emitting device 100. In this case, the reflective layer 110 may have a highest reflectance with respect to light having an emission wavelength band of the light-emitting device 100. For example, when the light-emitting device 100 is a red light-emitting device, the width dimension WD of each nano-structure 111 of the phase modulation surface, the height H of each nano-structure 111, the interval S between two adjacent nano-structures 111, and the period P of the plurality of nano-structures 111 may be selected so that the resonance wavelength of the micro-cavity corresponds to a red wavelength band. In this way, the emission wavelength of the light-emitting device 100 may be determined only by using a structure of the phase modulation surface of the reflective layer 110.

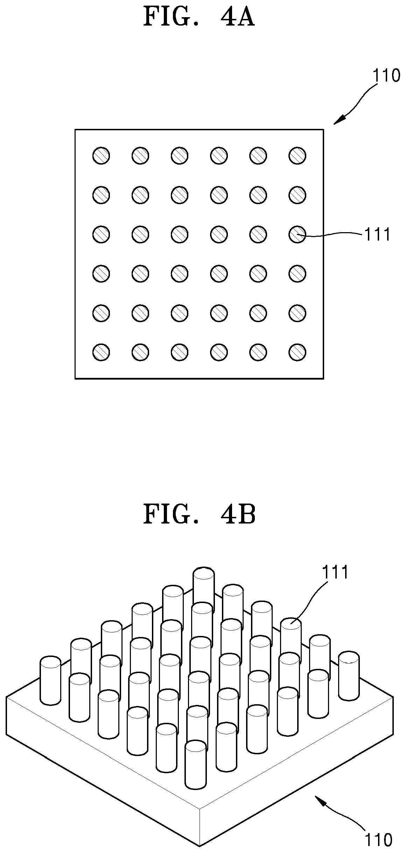

For example, FIG. 4A is a plan view illustrating an arrangement of the plurality of nano-structures 111 of the reflective layer 110 of FIG. 1. FIG. 4B is a perspective view illustrating an arrangement of the plurality of nano-structures 111 of the reflective layer 110 of FIG. 1. Referring to FIGS. 4A and 4B, the plurality of nano-structures 111 each having a cylindrical shape may be two-dimensionally arranged in a regular square array. Although the nano-structure 111 has a cylindrical shape in FIGS. 4A and 4B, a shape of the nano-structure 111 is not limited thereto. The nano-structure 111 may have any of various cross-sectional shapes having 2-fold symmetry. For example, the nano-structure 111 may have a cylindrical shape, an elliptical column shape, a polygonal column shape such as a pentagonal column shape or the like, or a cross-like column shape.

Also, in order to prevent the micro-cavity from having polarization dependence, the plurality of nano-structures 111 may be regularly and periodically arranged to have 4-fold symmetry. When the micro-cavity has the polarization dependence, only light of a specific polarization component may resonate, thereby reducing the luminous efficiency of the light-emitting device 100. In FIGS. 4A and 4B, the nano-structures 111 are arranged in a regular square array. However, the nano-structures 111 may be arranged in any of other arrays as long as the nano-structures 111 have 4-fold symmetry. For example, the plurality of nano-structures 111 may be two-dimensionally arranged in a hexagonal array, or two-dimensionally arranged in a body-centered square array.

In another example embodiment, the arrangement of the plurality of nano-structures 111 may be designed to be different from 4-fold symmetry so that the light-emitting device 100 intentionally emits only light of a specific polarization component. For example, the plurality of nano-structures 111 may be arranged in a one-dimensional array pattern.

In order to apply the light-emitting device 100 to an ultra-high resolution display apparatus with 10,000 pixels per inch (PPI), the light-emitting device 100 may have a small size such as a sub-micron size. For example, a width W of the light-emitting device 100 may be equal to or less than 4 µm, equal to or less than 2 µm, or equal to or less than 1 µm. As a size of the light-emitting device 100 decreases, the number of the nano-structures 111 disposed in the reflective layer 110 decreases. In this case, collective characteristics due to the periodicity of the plurality of nano-structures 111 may be reduced, thereby reducing luminous efficiency. Accordingly, in order to implement the light-emitting device 100 having a small size such as a sub-micron size, the interval S between two adjacent nano-structures 111 may be reduced.

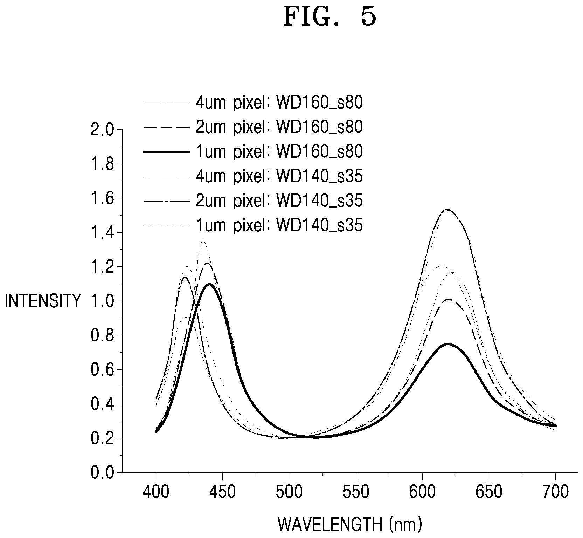

FIG. 5 is a graph illustrating emission characteristics of the light-emitting device 100 according to a size of the light-emitting device 100 and an interval between two adjacent nano-structures 111. The organic emission layer 130 of the light-emitting device 100 was configured to emit white light, and a height and a period of the nano-structure 111 of the reflective layer 110 were selected so that a resonance wavelength of a micro-cavity corresponds to a red wavelength band.

First, it is found that, when a width dimension of each nano-structure 111 is 160 nm and an interval between two adjacent nano-structures 111 is 80 nm, the luminous efficiency of the light-emitting device 100 rapidly decreases as a width of the light-emitting device 100 decreases to 4 µm, 2 µm, and 1 µm. Heights of the plurality of nano-structures 111 were all 50 nm. Also, light of an ultraviolet or blue wavelength band in the micro-cavity may cause third order resonance to be emitted from the light-emitting device 100, and a peak of the ultraviolet or blue wavelength band is similar to a peak of the red wavelength band.

In contrast, when an interval between two nano-structures 111 is reduced, the luminous efficiency of the light-emitting device 100 may be improved. For example, when a width dimension of each nano-structure 111 was 140 nm and an interval between two adjacent nano-structures 111 was 35 nm, the luminous efficiency of the light-emitting device 100 in the red wavelength band greatly increased. Also, even as a width of the light-emitting device 100 decreased to 4 µm, 2 µm, and 1 µm, luminous efficiency did not rapidly decrease. The luminous efficiency of the light-emitting device 100 in which an interval between two adjacent nano-structures 111 is 35 nm and a width is 1 µm is higher than the luminous efficiency of the light-emitting device 100 in which an interval between two adjacent nano-structures 111 is 80 nm and a width is 4 µm.

Also, when an interval between two nano-structures 111 is reduced, a peak of a wavelength band other than the red wavelength band generated in the micro-cavity of the light-emitting device 100 is shifted toward a short wavelength. For example, a peak of the blue wavelength band may be shifted to an ultraviolet region and may not be visible to the human eye. Referring to FIG. 5, it is found that, when an interval between two nano-structures 111 is reduced to 35 nm, an intensity of a blue wavelength of about 450 nm visible to the human eye is greatly reduced. Accordingly, when a size of the light-emitting device 100 decreases, a decrease in efficiency and color purity of the light-emitting device 100 may be prevented by reducing an interval between two adjacent nano-structures 111. For example, an interval between two adjacent nano-structures 111 in an entire portion of the reflective layer 110 may be equal to or less than 70 nm, and an interval between adjacent nano-structures 111, and a width dimension WD, a period, and a height of the nano-structures 111 in the entire portion of the reflective layer 110 may be the same.

Collective plasmon resonance mainly occurs in a central portion of a phase modulation surface of the reflective layer 110. According to an example embodiment, plasmon resonance occurs in a gap space between nan-ostructures 111. According to an example embodiment, the plasmon resonance occurs generally in the gap space between nano-structures 111, except at an outermost gap. The outermost gap may be a gap between the outermost nano-structure 111 and a neighboring nano-structure 111 thereof. The range of the plasmon resonance occurrence in the gap space between nano-structures 111 varies depending on the structure (i.e., gap structure) and the number of arrays. However, the disclosure is not limited thereto. As a size of the light-emitting device 100 decreases, a proportion of an edge portion may relatively increase and a resonance area of a target wavelength may decrease. Also, when an interval between the nano-structures 111 in the entire portion of the reflective layer 110 is reduced to improve luminous efficiency, a phase shift may be increased, the resonance wavelength of the micro-cavity may be shifted toward a long wavelength, and color reproduction may be degraded. Considering these points, the phase modulation surface having hetero-nano-structures may be designed. For example, when a period of the plurality of nano-structures 111 or an interval between two adjacent nano-structures 111 is reduced to 70 nm or less only in the central portion of the reflective layer 110, or when a period of the plurality of nano-structures 111 or an interval between two adjacent nano-structures 111 is reduced to 70 nm or less only in the edge portion of the reflective layer 110, a shift of a resonance wavelength may be minimized and the luminous efficiency of a target wavelength may be improved.

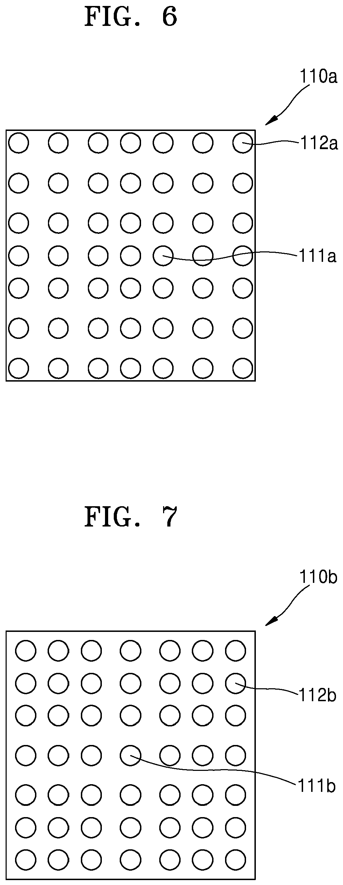

FIG. 6 is a plan view illustrating an arrangement of a plurality of nano-structures in a reflective layer, according to an example embodiment. Referring to FIG. 6, a reflective layer 110a may include a plurality of first nano-structures 111a arranged in a central portion, and a plurality of second nano-structures 112a arranged in a peripheral portion surrounding the central portion. The second nano-structures 112a arranged in the peripheral portion of the reflective layer 110a may be arranged so that a resonance wavelength of a micro-cavity corresponds to a green wavelength band, and the first nano-structures 111a arranged in the central portion may be more densely arranged than the second nano-structures to improve luminous efficiency.

Accordingly, an interval between two adjacent nano-structures 111a from among the plurality of first nano-structures 111a arranged in the central portion may be less than an interval between two adjacent nano-structures 112a from among the plurality of second nano-structures 112a arranged in the peripheral portion. Also, a period of the plurality of first nano-structures 111a arranged in the central portion may be less than a period of the plurality of second nano-structures 112a arranged in the peripheral portion. Width dimension of the nano-structures in an entire portion of the reflective layer 110a may be the same. In other words, a width dimension of each nano-structure of the plurality of first nano-structures 111a may be the same as a width dimension of each nano-structure of the plurality of second nano-structures 112a. However, the present disclosure is not limited thereto, and according to a design, a width dimension of each nano-structure of the first nano-structure 111a may be slightly different from a width dimension of each nano-structure of the plurality of second nano-structures 112a.

For example, in the reflective layer 110a of FIG. 6, a width of a light-emitting device may be 1 µm, a width dimension of the first nano-structure 111a may be 80 nm, and an interval between the first nano-structures 111a may be 50 nm. Also, a width dimension of the second nano-structure 112a may be 80 nm, and an interval between the second nano-structures 112a may be 80 nm. Heights of both the first nano-structure 111a and the second nano-structure 112a may be 50 nm. Accordingly, a period of the first nano-structures 111a and a period of the second nano-structures 112a are less than an emission wavelength band of the light-emitting device.

FIG. 7 is a plan view illustrating an arrangement of a plurality of nano-structures in a reflective layer, according to another example embodiment. Referring to FIG. 7, a reflective layer 110b may include a plurality of first nano-structures 111b arranged in a central portion, and a plurality of second nano-structures 112b arranged in a peripheral portion surrounding the central portion. The first nano-structures 111b arranged in the central portion of the reflective layer 110b may be arranged so that a resonance wavelength of a micro-cavity corresponds to a green wavelength band, and the second nano-structures 112b arranged in the peripheral portion may be more densely arranged than the first nano-structures 111b to improve luminous efficiency.

Accordingly, an interval between two adjacent nano-structures from among the plurality of second nano-structures 112b arranged in the peripheral portion may be less than an interval between two adjacent nano-structures from among the plurality of first nano-structures 111b arranged in the central portion. Also, a period of the plurality of second nano-structures 112b arranged in the peripheral portion may be less than a period of the plurality of first nano-structures 111b arranged in the central portion. Width dimensions of nano-structures in an entire portion of the reflective layer 110b may be the same or may be slightly different.

For example, in the reflective layer 110b of FIG. 7, a width of a light-emitting device may be 1 µm, a width dimension of the first nano-structure 111b may be 80 nm, and an interval between the first nano-structures 111b may be 80 nm. Also, a width dimension of the second nano-structure 112b may be 80 nm, and an interval between the second nano-structures 112b may be 50 nm. Heights of both the first nano-structure 111b and the second nano-structure 112b may be 50 nm.

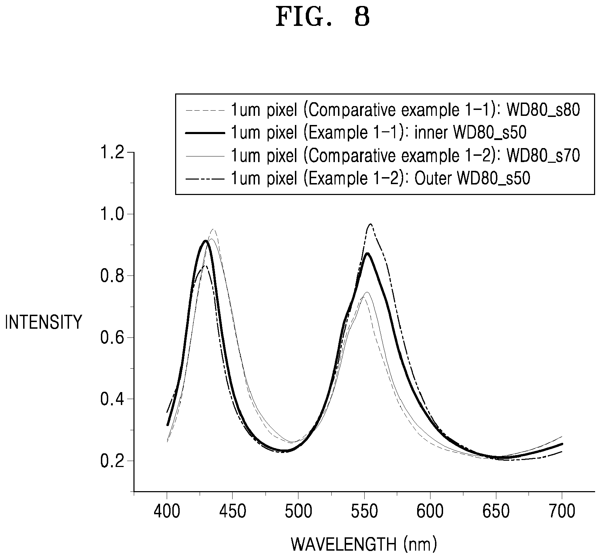

FIG. 8 is a graph illustrating emission characteristics of light-emitting devices including reflective layers of FIGS. 6 and 7. In order to compare with Example 1-1 of the light-emitting device including the reflective layer 110a illustrated according to an example embodiment in FIG. 6 and Example 1-2 of the light-emitting device including the reflective layer 110b illustrated according to an example embodiment in FIG. 7, emission characteristics of Comparative Example 1-1 including a reflective layer in which a width dimension in an entire portion is 80 nm and an interval between nano-structures is 80 nm and emission characteristics of Comparative Example 1-2 including a reflective layer in which a width dimension in an entire portion is 80 nm and an interval between nano-structures is 70 nm are also illustrated. A width of a light-emitting device in each of Comparative Example 1-1 and Comparative Example 1-2 is 1 µm.

Referring to FIG. 8, it is found that, in a green wavelength band of about 550 nm, luminous efficiency of Example 1-1 is higher than luminous efficiency of Comparative Example 1-1 and Comparative Example 1-2. For example, in the green wavelength band, an emission peak of Example 1-1 is about 20% higher than that of Comparative Example 1-1. Also, an emission wavelength of Example 1-1 is shifted by about 3 nm toward a long wavelength than an emission wavelength of Comparative Example 1-1. Although luminous efficiency of Comparative Example 1-2 is slightly higher than that of Comparative Example 1-1 and an emission peak of Comparative Example 1-2 in the green wavelength band is more slightly shifted toward a long wavelength than that of Comparative Example 1-1, a difference between Comparative Examples 1-2 and 1-1 is not significant. Also, in the green wavelength band, luminous efficiency of Example 1-2 is higher than that of Example 1-1. Accordingly, in the green wavelength band, luminous efficiency of Example 1-2 is the highest. Also, in the green wavelength band, an emission peak of Example 1-2 is more slightly shifted toward a long wavelength than Example 1-1.

When comparing a light intensity of a blue wavelength band of about 450 nm, a light intensity of a blue wavelength of Example 1-1 is about 64% lower than that of Comparative Example 1-1, and a light intensity of a blue wavelength of Example 1-2 is slightly lower than that of Example 1-1. That is, a blue wavelength peak decreases at the target green pixel in the Example 1-2 as compared to the Example 1-1. Accordingly, when a width of the light-emitting device is as small as 1 µm, luminous efficiency and color purity of Example 1-1 are higher than those of Comparative Example 1-1, and luminous efficiency and color purity of Example 1-2 are higher than those of Example 1-1. A light intensity of a blue wavelength of 450 nm of Comparative Example 1-2 is similar to that of Comparative Example 1-1.

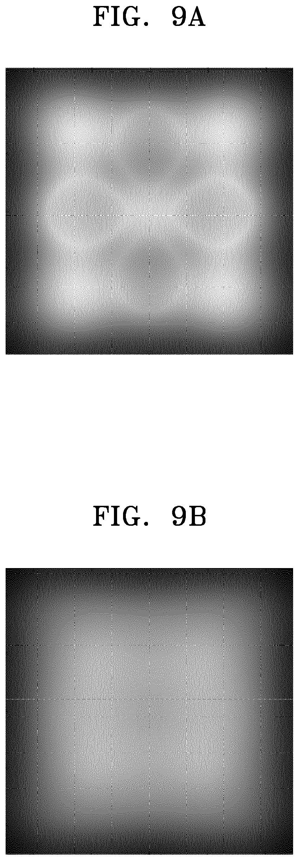

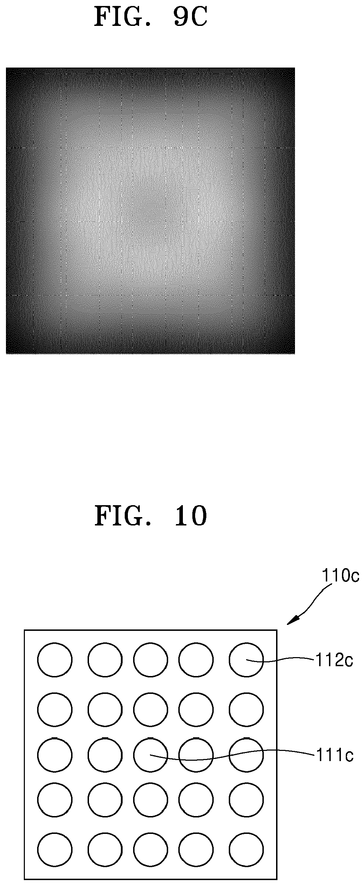

FIG. 9A is a view illustrating an emission area and an emission intensity inside an organic emission layer of the light-emitting device including the reflective layer 110a of FIG. 6. FIGS. 9B and 9C are views each illustrating an emission area and an emission intensity inside an organic emission layer of the light-emitting device according to Comparative Example 1-1 and Comparative Example 1-2. As shown in FIGS. 9A through 9C, it is found that an emission area increases and an emission intensity increases in the organic emission layer according to Example 1-1. As such, when the emission area in the organic emission layer increases, an organic emission material in the organic emission layer is uniformly used, and thus the lifespan of the organic emission material, that is, the lifespan of the light-emitting device, may increase.

FIG. 10 is a plan view illustrating an arrangement of a plurality of nano-structures in a reflective layer, according to another example embodiment. Referring to FIG. 10, a reflective layer 110c may include a plurality of first nano-structures 111c arranged in a central portion, and a plurality of second nano-structures 112c arranged in a peripheral portion surrounding the central portion. The second nano-structures 112c arranged in the peripheral portion of the reflective layer 110c may be arranged so that a resonance wavelength of a micro-cavity corresponds to a red wavelength band, and the first nano-structures 111c arranged in the central portion may be more densely arranged than the second nano-structures 112c to improve luminous efficiency. Width dimensions of the first nano-structure 111c and the second nano-structure 112c may be the same, and a period and an interval of the first nano-structures 111c are less than a period and an interval of the second nano-structures 112c. However, in another example embodiment, width dimensions of the first nano-structure 111c and the second nano-structure 112c may be different from each other.

Because phase modulation by the reflective layer 110c when a target wavelength is a red wavelength is greater than that when a target wavelength is a green wavelength, width dimensions of the first nano-structure 111c and the second nano-structure 112c are increased. Accordingly, the number of the first nano-structures 111c and the second nano-structures 112c arranged in the reflective layer 110c may be less than the number of the first nano-structures 111a and 111b and the second nano-structures 112a and 112b arranged in the reflective layers 110a and 110b.

For example, in the reflective layer 110c of FIG. 10, a width of a light-emitting device is 1.2 µm, a width dimension of the first nano-structure 111c is 160 nm, and an interval between the first nano-structures 111c is 50 nm. Also, a width dimension of the second nano-structure 112c is 160 nm, and an interval between the second nano-structures 112c is 80 nm. Heights of both the first nano-structure 111c and the second nano-structure 112c are 50 nm.

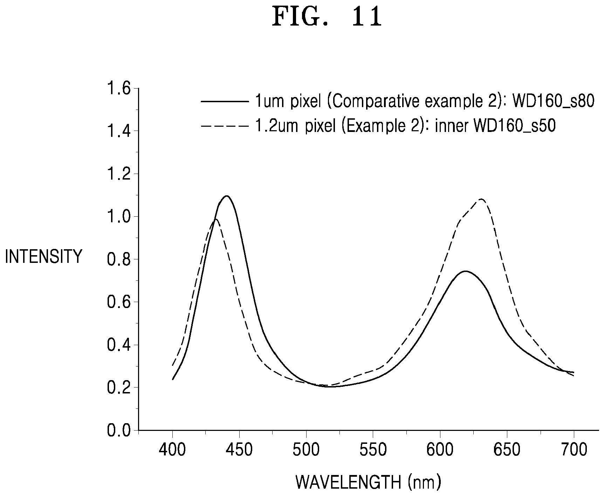

FIG. 11 is a graph illustrating emission characteristics of the light-emitting device including the reflective layer 110c of FIG. 10. In order to compare with Example 2 of the light-emitting device including the reflective layer 110c illustrated according to an example embodiment in FIG. 10, optical characteristics of Comparative Example 2 including a reflective layer in which a width dimension in an entire portion is 160 nm and an interval between nano-structures is 80 nm are also illustrated. A width of a light-emitting device of Comparative Example 2 is 1 µm.

Referring to FIG. 11, it is found that, in a red wavelength band of about 650 nm, luminous efficiency of Example 2 is higher than luminous efficiency of Comparative Example 2. For example, in the red wavelength band, an emission peak of Example 2 is about 50% higher than that of Comparative Example 2. Also, an emission wavelength of Example 2 is more shifted by about 3 nm toward a long wavelength than an emission wavelength of Comparative Example 2. Also, when comparing a light intensity of a blue wavelength of 450 nm, a light intensity of a blue wavelength of Example 2 is about 62% lower than that of Comparative Example 2.

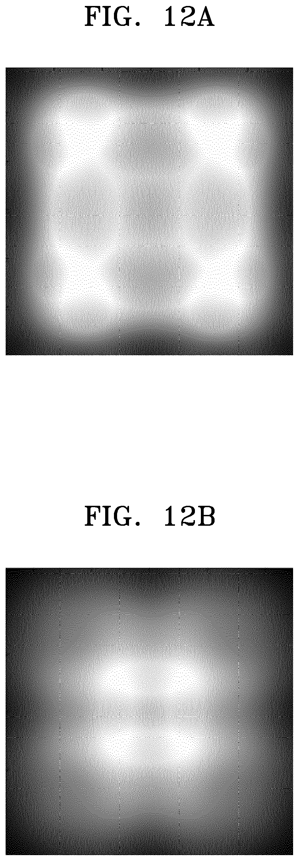

FIG. 12A is a view illustrating an emission area and an emission intensity inside an organic emission layer of the light-emitting device including the reflective layer 110c of FIG. 10. FIG. 12B is a view illustrating an emission area and an emission intensity inside an organic emission layer of the light-emitting device of Comparative Example 2. As shown in FIGS. 12A and 12B, it is found that an emission area and an emission intensity in the organic emission layer of Example 2 are higher than those of Comparative Example 2. Also, it is found that an overall emission intensity in the organic emission layer of Example 2 is uniform.

Although widths of the light-emitting devices in FIGS. 6, 7, and 10 were 1 µm and 1.2 µm, a size of a light-emitting device may be greater or less than 1 µm and 1.2 µm. For example, a width of a light-emitting device may be equal to or less than 2 µm. When a width of a light-emitting device is 2 µm, more first nano-structures and second nano-structures may be arranged in a reflective layer.

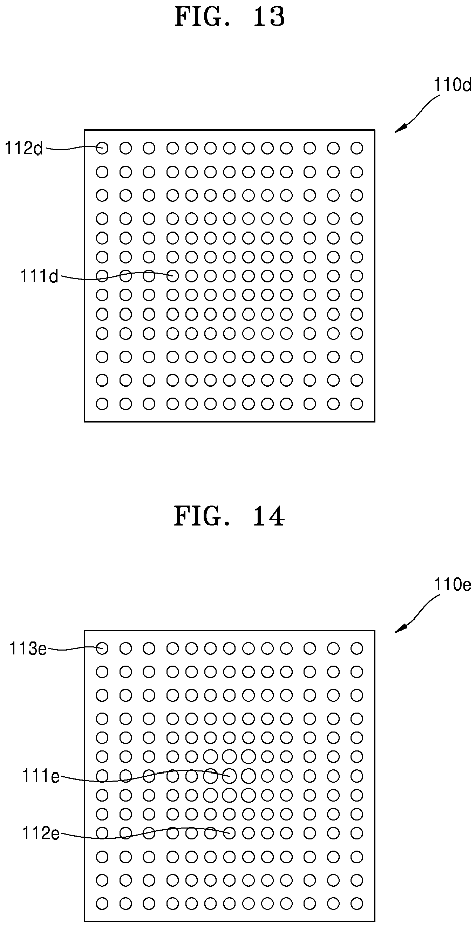

FIG. 13 is a plan view illustrating an arrangement of a plurality of nano-structures in a reflective layer, according to another example embodiment. Referring to FIG. 13, a reflective layer 110d may include a plurality of first nano-structures 111d arranged in a central portion, and a plurality of second nano-structures 112d arranged in a peripheral portion surrounding the central portion. The second nano-structures 112d arranged in the peripheral portion of the reflective layer 110d may be arranged so that a resonance wavelength of a micro-cavity corresponds to a green wavelength band, and the first nano-structures 111d arranged in the central portion may be more densely arranged than the second nano-structures 112d to improve luminous efficiency.

For example, in Example 3-1 including the reflective layer 110d illustrated according to an example embodiment in FIG. 13, a width of the light-emitting device is 2 µm, a width dimension of the first nano-structure 111d is 80 nm, and an interval between the first nano-structures 111d is 50 nm. Also, a width dimension of the second nano-structure 112d is 80 nm, and an interval between the second nano-structures 112d is 80 nm. Heights of both the first nano-structure 111d and the second nano-structure 112d are 50 nm.

Although a reflective layer includes two different arrangements of nano-structures in FIGS. 6, 7, 10, and 13, a reflective layer may include three or more different arrangements of nano-structures.

FIG. 14 is a plan view illustrating an arrangement of a plurality of nano-structures in a reflective layer, according to another example embodiment. Referring to FIG. 14, a reflective layer 110e may include a third nano-structure 113e arranged in an outermost portion of the reflective layer 110e and a first nano-structure 111e and a second nano-structure 112e arranged in an inner portion than the third nano-structure 113e. For example, the reflective layer 110e may include a plurality of first nano-structures 111e arranged in a central portion, a plurality of second nano-structures 112e arranged in a first peripheral portion directly surrounding the central portion, and a plurality of third nano-structures 113e arranged in a second peripheral portion directly surrounding the first peripheral portion. The third nano-structures 113e arranged in the second peripheral portion that is an outermost portion of the reflective layer 110e may be arranged so that a resonance wavelength of a micro-cavity corresponds to a green wavelength band, and the first nano-structures 111e and the second nano-structures 112e respectively arranged in the central portion and the first peripheral portion may be more densely arranged than the third nano-structures 113e to improve luminous efficiency. Also, the first nano-structures 111e arranged in the central portion may be arranged at narrower intervals than the second nano-structures 112e arranged in the first peripheral portion.

For example, in Example 3-2 including the reflective layer 110e illustrated according to an example embodiment in FIG. 14, a width of a light-emitting device is 2 µm, a width dimension of the first nano-structure 111e is 90 nm, an interval between the first nano-structures 111e is 40 nm, a width dimension of the second nano-structure 112e is 80 nm, an interval between the second nano-structures 112e is 50 nm, a width dimension of the third nano-structure 113e is 80 nm, and an interval between the third nano-structures 113e is 80 nm. Heights of the first nano-structure 111e, the second nano-structure 112e, and the third nano-structure 113e are all 50 nm. Accordingly, a period of the second nano-structures 112e is less than a period of the third nano-structures 113e, and a period of the first nano-structures 111e is the same as a period of the second nano-structures 112e. Also, a width dimension of the first nano-structure 111e is greater than a width dimension of the second nano-structure 112e, and a width dimension of the second nano-structure 112e is the same as a width dimension of the third nano-structure 113e. An interval between the first nano-structures 111e is less than an interval between the second nano-structures 112e, and an interval between the second nano-structures 112e is less than an interval between the third nano-structures 113e.

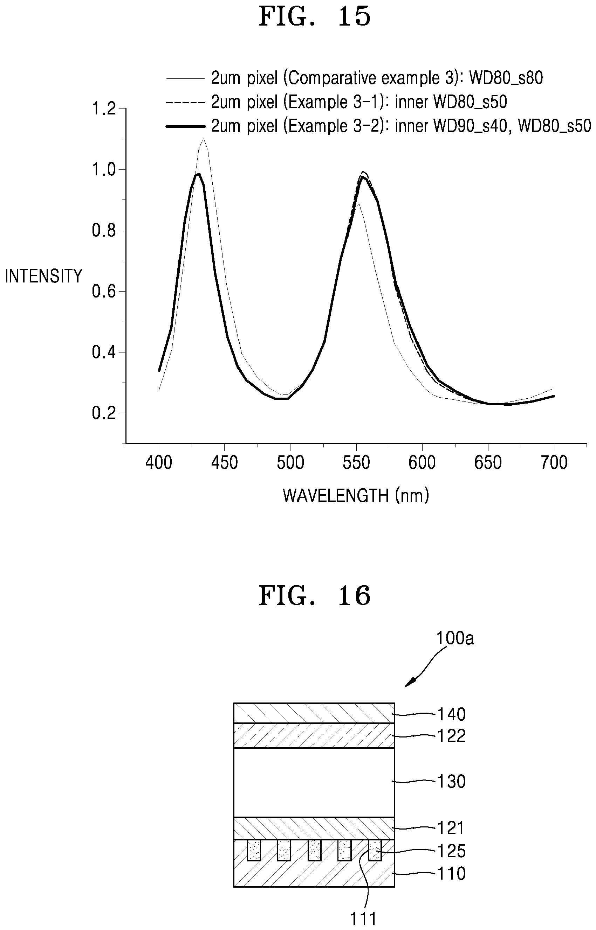

FIG. 15 is a graph illustrating emission characteristics of the light-emitting devices including the reflective layers 110d and 110e of FIGS. 13 and 14. In order to compare with Example 3-1 of the reflective layer 110d of FIG. 13 and Example 3-2 of the reflective layer 110e of FIG. 14, emission characteristics of Comparative Example 3 including a reflective layer in which a width dimension in an entire portion is 80 nm and an interval between nano-structures is 80 nm are also illustrated. A width of a light-emitting device in Comparative Example 3 is 2 µm.

Referring to FIG. 15, in a green wavelength band, emission peaks of Example 3-1 and Example 3-2 are about 10% to about 12% higher than that of Comparative Example 3. Also, emission wavelengths of Example 3-1 and Example 3-2 are more shifted by about 6 nm toward a long wavelength than an emission wavelength of Comparative Example 3. Also, when comparing a light intensity of a blue wavelength of 450 nm, light intensities of blue wavelengths of Example 3-1 and Example 3-2 are about 73% lower than that of Comparative Example 3. Example 3-1 and Example 3-2 show almost similar emission characteristics.

Structures of the reflective layers 110d and 110e of FIGS. 13 and 14 may be applied to a light-emitting device having a red emission wavelength, and in this case, dimensions related to nano-structures may vary according to the red emission wavelength. Also, structures of the reflective layers 110a, 110b, 110c, 110d, and 100e may be applied to a light-emitting device having a blue emission wavelength, and dimensions related to nano-structures may vary according to the blue emission wavelength. For example, an interval between adjacent nano-structures in a central portion of a reflective layer may be equal to or less than 70 nm. An interval between adjacent nano-structures in the central portion of the reflective layer may be selected in a range from about 10 nm to about 70 nm. Also, an interval between adjacent nano-structures in a peripheral portion surrounding the central portion of the reflective layer may be equal to or less than 80 nm. An interval between adjacent nano-structures in the peripheral portion surrounding the central portion of the reflective layer may be selected in a range from about 30 nm to about 80 nm. In contrast, an interval between adjacent nano-structures in a peripheral portion of a reflective layer may be equal to or less than 70 nm, and an interval between adjacent nano-structures in a central portion of the reflective layer may be equal to or less than 80 nm. Also, a width dimension of each nano-structure may be selected in a range from about 50 nm to about 200 nm, and a period of the plurality of nano-structures may be selected in a range from about 70 nm to about 300 nm. Although a height of each nano-structure in the above example embodiments is 50 nm, a height of each nano-structure may be selected to be 200 nm or less.

Although the first nano-structures 111e are arranged in the central portion of the reflective layer 110e, the second nano-structures 112e are arranged in the first peripheral portion surrounding the central portion, and the third nano-structures 113e arranged in the second peripheral portion surrounding the first peripheral portion in FIG. 14, this is merely an example and the present disclosure is not limited thereto. For example, the third nano-structures 113e may be arranged in an outermost portion of the reflective layer 110e, and the first nano-structures 111e and the second nano-structures 112e may be arranged together in a central portion of the reflective layer 110e. Also, additional nano-structures arranged at intervals different from an interval between the first nano-structures 111e and an interval between the second nano-structures 112e may be disposed in an inner portion than the third nano-structures 113e. An arrangement interval of the additional nano-structures disposed in an inner portion than the third nano-structures 113e may be different from an arrangement interval of the third nano-structures 113e. Or, an interval between the first nano-structures 111e arranged in a central portion of the reflective layer 110e may be the largest, and an interval between the third nano-structures 113e in an outermost portion of the reflective layer 110e may be the smallest. Also, a width dimension of the first nano-structure 111e, a width dimension of the second nano-structure 112e, and a width dimension of the third nano-structure 113e may be selected to be different from those described above according to design conditions such as an emission wavelength of a light-emitting device and a width of the emission device.

FIG. 16 is a cross-sectional view illustrating a structure of a light-emitting device, according to another example embodiment. Referring to FIG. 16, a light-emitting device 100a may further include a dielectric 125 filled in a space between the nano-structures 111. The dielectric 125 that is an insulating material transparent to visible light may include, for example, an inorganic material such as SiO₂, SiNₓ, Al₂O₃, or HfO₂, an organic material such as a polymer, acrylic, or epoxy, or a combination thereof. A resonance wavelength of a micro-cavity may be finely adjusted according to a refractive index of the dielectric 125. A height of a top surface of the dielectric 125 may be the same as a height of a top surface of the nano-structure 111. In this case, a bottom surface of the first electrode 121 may be flat.

As described above, when the reflective layer 110 including the plurality of nano-structures 111 is used, an emission wavelength of the light-emitting device may be determined by adjusting the optical length L of the micro-cavity. In this case, the emission wavelength of the light-emitting device may be determined by using only dimensions related to the plurality of nano-structures 111 while fixing a physical length of the micro-cavity. Accordingly, when the light-emitting device according to an example embodiment is applied to RGB sub-pixels of a display apparatus, a process of manufacturing the display apparatus is simplified. Also, when different types of nano-structures 111 are arranged in a central portion and a peripheral portion of the reflective layer 110, high luminous efficiency and high color purity may be achieved even in a sub-micron sized organic light-emitting device. Accordingly, an ultra-high resolution display apparatus with sub-micron pixels and a resolution of 10,000 PPI may be provided.

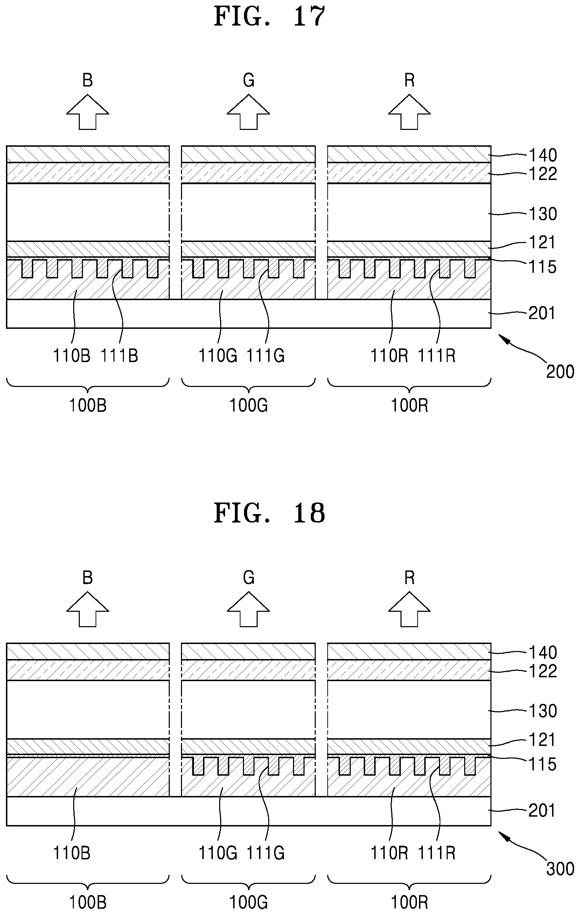

FIG. 17 is a cross-sectional view illustrating a structure of a display apparatus, according to an example embodiment. Referring to FIG. 17, a display apparatus 200 according to an example embodiment may include a display substrate 201 and a first pixel 100B, a second pixel 100G, and a third pixel 100R aligned on the display substrate 201. In FIG. 17, although each of the first through third pixels 100B, 100G, and 100R has the same structure as that of the light-emitting device 100 of FIG. 1, each of the first through third pixels 100B, 100G, and 100R may have a structure of the light-emitting device 100a of FIG. 16. Also, although only one first pixel 100B, one second pixel 100G, and one third pixel 100R are illustrated for convenience of explanation in FIG. 17, a large number of first through third pixels 100B, 100G, and 100R may be actually repeatedly arranged.

The first through third pixels 100B, 100G, and 100R may include reflective layers 110B, 110G, and 110R respectively including a plurality of nano-structures 111B, 111G, and 111R that are two-dimensionally arranged, the planarization layer 115 disposed on the reflective layers 110B, 110G, and 110R, the first electrode 121 disposed on the planarization layer 115, the organic emission layer 130 disposed on the first electrode 121, and the second electrode 122 disposed on the organic emission layer 130. Also, the first through third pixels 100B, 100G, and 100R may further include the passivation layer 140 that is transparent and is disposed on the second electrode 122 to protect the second electrode 122.

The first through third pixels 100B, 100G, and 100R may be configured to emit light having different wavelengths. For example, the first pixel 100B may be configured to emit light B of a blue wavelength band, the second pixel 100G may be configured to emit light G of a green wavelength band, and the third pixel 100R may be configured to emit light R of a red wavelength band. To this end, the reflective layers 110B, 110G, and 110R of the first through third pixels 100B, 100G, and 100R may respectively include the nano-structures 111B, 111G, and 111R having different dimensions.

For example, an interval between adjacent nano-structures 111B, 111G, and 111R arranged in central portions of the reflective layers 110B, 110G, and 110R of the first through third pixels 100B, 100G, and 100R may be different from an interval between adjacent nano-structures 111B, 111G, and 111R arranged in peripheral portions. In particular, any one of an interval between adjacent nano-structures 111B, 111G, and 111R arranged in the central portions of the reflective layers 110B, 110G, and 110R and an interval between adjacent nano-structures 111B, 111G, and 111R arranged in the peripheral portions of the reflective layers 110B, 110G, and 110R may be equal to or less than 70 nm. Or, an interval between adjacent nano-structures 111B and 111G arranged in the central portions of the reflective layers 110B and 110G of the first and second pixels 100B and 100G may be different from an interval between adjacent nano-structures 111B and 111G arranged in the peripheral portions surrounding the central portions, and an interval between adjacent nano-structures 111R in an entire portion of the reflective layer 110R of the third pixel 100R may be equal to or less than 70 nm. An emission wavelength is relatively largely shifted toward a long wavelength when an interval between adjacent nano-structures 111R in the entire portion of the reflective layer 110R uniformly is reduced, which may be advantageous for the third pixel 100R emitting red light. Also, a period and a width dimension of the nano-structures 111B of the reflective layer 110B of the first pixel 100B may be less than a period and a width dimension of the nano-structures 111G of the reflective layer 110G of the second pixel 100G, and a period and a width dimension of the nano-structures 111G of the reflective layer 110G of the second pixel 100G may be less than a period and a width dimension of the nano-structures 111R of the reflective layer 110R of the third pixel 100R.

Physical lengths of micro-cavities in the first through third pixels 100B, 100G, and 100R may be the same, and emission wavelengths of the first through third pixels 100B, 100G, and 100R may be determined only by using dimensions of the nano-structures 111B, 111G, and 111R in the reflective layers 110B, 110G, and 110R. Also, in the first through third pixels 100B, 100G, and 100R, elements other than the reflective layers 110B, 110G, and 110R, for example, the first electrode 121, the organic emission layer 130, and the second electrode 122, may have the same composition and the same thickness. As a result, physical thicknesses of the first through third pixels 100B, 100G, and 100R may be the same. Accordingly, a method of manufacturing the display apparatus 200 may be simplified and manufacturing costs may be reduced.

FIG. 18 is a cross-sectional view illustrating a structure of a display apparatus, according to another example embodiment. In a display apparatus 300 of FIG. 18, the reflective layers 110G and 110R of the second pixel 100G and the third pixel 100R respectively include the nano-structures 111G and 111R, but the reflective layer 110B of the first pixel 100B emitting blue light may not include nano-structures. In this case, in the first pixel 100B, an optical length of a micro-cavity may be determined so that a resonance wavelength of the micro-cavity corresponds to a blue wavelength band. For example, the optical length of the micro-cavity of the first pixel 100B may be determined to be a sum of optical lengths of materials disposed between the reflective layer 110B and the second electrode 122.

In the second and third pixels 100G and 100R, a resonance wavelength of a micro-cavity may be adjusted through a phase shift of reflected light by using the nano-structures 111G and 111R. According to an example embodiment, an interval between adjacent nano-structures 111G and 111R arranged in central portions of the reflective layers 110G and 110R of the second and third pixels 100G and 100R may be different from an interval between adjacent nano-structures 111G and 111R arranged in peripheral portions. According to another example embodiment, an interval between adjacent nano-structures 111G arranged in the central portion of the reflective layer 110G of the second pixel 100G may be different from an interval between adjacent nano-structures 111G arranged in the peripheral portion surrounding the central portion, and an interval between adjacent nano-structures 111R in an entire portion of the reflective layer 110R of the third pixel 100R emitting red light may be equal to or less than 70 nm.

It should be understood that example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by one of ordinary skill in the art that various changes in form and details may be made therein without departing from the scope as defined by the following claims.

## Claims

1. A light-emitting device comprising:
a reflective layer comprising a plurality of nano-structures that are two-dimensionally arranged in a regular periodic structure;
a first electrode provided on the plurality of nano-structures of the reflective layer;
an organic emission layer provided on the first electrode; and
a second electrode provided on the organic emission layer,
and
wherein an interval between adjacent nano-structures in a central portion of the reflective layer or an interval between adjacent nano-structures in a peripheral portion surrounding the central portion of the reflective layer is equal to or less than 70 nm.

2. The light-emitting device of claim 1, wherein the reflective layer and the second electrode form a micro-cavity having a resonance wavelength, and the resonance wavelength of the micro-cavity is based on a width of each of the plurality of nano-structures, a height of each of the plurality of nano-structures, an interval between adjacent nano-structures, among the plurality of nano-structures, and a periodicity of the plurality of nano-structures,

3. The light-emitting device of claim 1 or 2, wherein the width of each of the plurality of nano-structures of the reflective layer, the height of each of the plurality of nano-structures, the interval between the adjacent nano-structures, and the periodicity of the plurality of nano-structures are configured so that the resonance wavelength of the micro-cavity is matched to an emission wavelength of the light-emitting device.

4. The light-emitting device of any preceding claim, wherein the periodicity of the plurality of nano-structures is less than an emission wavelength band of the light-emitting device, and optionally wherein the periodicity of the plurality of nano-structures ranges from 70 nm to 300 nm.

5. The light-emitting device of any preceding claim, wherein the height of each of the plurality of nano-structures is equal to or less than 200 nm, and
wherein each of the plurality of nano-structures of the reflective layer has a same height.

6. The light-emitting device of any preceding claim, wherein the width of each of the plurality of nano-structures of the reflective layer ranges from 50 nm to 200 nm.

7. The light-emitting device of any preceding claim, wherein the interval between the adjacent nano-structures in the central portion of the reflective layer or the interval between the adjacent nano-structures in the peripheral portion of the reflective layer ranges from 10 nm to 70 nm.

8. The light-emitting device of any preceding claim, wherein a width of the light-emitting device is equal to or less than 2 µm.

9. The light-emitting device of any preceding claim, wherein the reflective layer comprises a plurality of first nano-structures arranged in the central portion of the reflective layer and a plurality of second nano-structures arranged in the peripheral portion of the reflective layer,
wherein a first interval between two adjacent nano-structures from among the plurality of first nano-structures is less than a second interval between two adjacent nano-structures from among the plurality of second nano-structures, and optionally wherein a first width of each of the plurality of first nano-structures is same as a second width of each of the plurality of second nano-structures.

10. The light-emitting device of any preceding claim, wherein the reflective layer comprises a plurality of first nano-structures arranged in the central portion of the reflective layer and a plurality of second nano-structures arranged in the peripheral portion of the reflective layer,
wherein a first interval between two adjacent nano-structures from among the plurality of second nano-structures is less than a second interval between two adjacent nano-structures from among the plurality of first nano-structures.

11. The light-emitting device of any of claims 1 to 9, wherein the reflective layer comprises a plurality of first nano-structures and a plurality of second nano-structures arranged in the central portion of the reflective layer, and a plurality of third nano-structures arranged in the peripheral portion of the reflective layer,
wherein a first interval between two adjacent nano-structures from among the plurality of first nano-structures is different from a second interval between two adjacent nano-structures from among the plurality of second nano-structures, and the second interval between two adjacent nano-structures from among the plurality of second nano-structures is different from a third interval between two adjacent nano-structures from among the plurality of third nano-structures, and optionally wherein a first periodicity of the plurality of first nano-structures is same as a second periodicity of the plurality of second nano-structures.

12. The light-emitting device of claim 11, wherein a first width of each of the plurality of first nano-structures is different from a second width of each of the plurality of second nano-structures, and the second width of each of the plurality of second nano-structures is same as a third width of each of the plurality of third nano-structures.

13. The light-emitting device of claim 11 or 12, wherein the plurality of first nano-structures and the plurality of second nano-structures are arranged together in the central portion of the reflective layer, and optionally wherein the second interval between two adjacent nano-structures from among the plurality of second nano-structures is less than the third interval between two adjacent nano-structures from among the plurality of third nano-structures, and a first periodicity of the plurality of first nano-structures is less than a thirdperiodicity of the plurality of third nano-structures, and a second periodicity period of the plurality of second nano-structures is less than a third periodicity of the plurality of third nano-structures.

14. The light-emitting device of any preceding claim, wherein the interval between adjacent nano-structures in an entire portion of the reflective layer is same.

15. A display apparatus comprising:
a first pixel comprising a light-emitting device according to any preceding claim and configured to emit light of a first wavelength band; and
a second pixel configured to emit light of a second wavelength band different from the first wavelength band.
